(19) Europäisches Patentamt
European Patent Office
Office européen des brevets

(11) **EP 2 546 663 A1**

(12) **EUROPEAN PATENT APPLICATION**

(43) Date of publication:
**16.01.2013 Bulletin 2013/03**

(51) Int Cl.:
***G01R 23/15*** *(2006.01)*     ***G01R 23/10*** *(2006.01)*

(21) Application number: **11182869.5**

(22) Date of filing: **27.09.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.07.2011 TW 100125217**

(71) Applicants:
• **Askey Technology (Jiangsu) Ltd.
Economic-Technological Development Area
Wujiang Jiangsu (CN)**
• **Askey Computer Corp.
New Taipei City 235 (TW)**

(72) Inventors:
• **Chou, Ming-Hung
110 Taipei City (TW)**
• **Wang, Nai-Jian
106 Taipei City (TW)**
• **Hsieh, Ching-Feng
108 Taipei City (TW)**

(74) Representative: **Ciceri, Fabio et al
Perani & Partners
Piazza San Babila, 5
20122 Milano (IT)**

(54) **Method and system for measuring frequency**

(57)     A method for measuring frequency includes the steps of obtaining the cycle number of the clock rate of a signal under test (Fi) based on a reference signal (Fb) and a clock mask (mk) synchronous with the signal under test; obtaining a frequency of the signal under test based on the cycle number (Ni); correcting the frequency of the signal under test based on a plurality of phase shift signals (Fb-pi) generated based on the reference signal; and minimizing an error of the frequency of the signal under test by increasing the quantity of the phase shift signals. The method enhances the accuracy of the obtained frequency of the signal under test, speeds up frequency measurement, and reduces the required circuit areas. A system for measuring frequency is further introduced for use with the method.

FIG. 1

**Description**

FIELD OF THE INVENTION

The present invention relates to methods and systems for measuring frequency, and more particularly, to a method and system for measuring frequency quickly and precisely.

BACKGROUND OF THE INVENTION

The frequency of a clock signal is usually measured with a frequency counter. In general, a gate duration of the frequency counter is set, and the number of the cycles of the clock signal within the gate duration is counted. Eventually, the frequency of the clock signal is calculated, using the quotient of the count value and the gate duration.
However, the cycle number of a clock signal within a gate duration is seldom an integer, and thus the method is likely to cause an error at the beginning and the end of the gate duration - underestimating or overestimating by a half cycle, for example. In view of this, to measure frequency, it is usually necessary to maximize the gate duration in order to handle as many cycles as possible and thereby reduce errors. However, the aforesaid solution is performed at the cost of a great increase in the testing time and decrease in resolution.

SUMMARY OF THE INVENTION

It is an objective of the present invention to enhance the speed and accuracy of frequency measurement.
Another objective of the present invention is to provide an automatic program-controlled method and system for measuring frequency.
In order to achieve the above and other objectives, the present invention provides a method for measuring frequency. The method is applicable to measuring a signal under test. The method comprises the steps of: providing a reference signal; generating a plurality of phase shift signals of a same frequency based on the reference signal, the phase shift signals being spaced apart from each other by a fixed phase; setting a clock mask, the clock mask starting from a first triggering state of the signal under test and ending at another first triggering state of the signal under test; counting a number $Nd1$ of second triggering states occurring to the phase shift signals during a period from commencement of the clock mask to occurrence of a first triggering state to the reference signal; counting a number $Nb$ of cycles of the reference signal within a range of the clock mask; counting a number $Ni$ of cycles of the signal under test within a range of the clock mask; counting a number $Nd2$ of second triggering states occurring to the phase shift signals during a period from termination of the clock mask to occurrence of a first triggering state to the reference signal; and obtaining the frequency of the signal under test $Fi$ by the equation: $Fi = \{Ni/[Nb + (Nd/M)]\} \times Fb$, wherein a frequency of the reference signal is denoted by $Fb$ and a number of the phase shift signals by $M$, with $Nd = (Nd1 - Nd2)$ and $M \geqq 2$.
In order to achieve the above and other objectives, the present invention provides a system for measuring frequency. The system is applicable to measuring a signal under test. The system comprises: a signal input end for receiving the signal under test; a count generator connected to the signal input end for receiving the signal under test, adapted for generating a reference signal of a frequency $Fb$, adapted for generating $M$ phase shift signals which are based on the reference signal, have a same frequency, and are spaced apart from each other by a fixed phase, adapted for generating a clock mask starting from a first triggering state of the signal under test and ending at another first triggering state of the signal under test, adapted for counting a number $Nd1$ of second triggering states occurring to the phase shift signals during a period from commencement of the clock mask to occurrence of a first triggering state to the reference signal, adapted for counting a number $Nb$ of instances of occurrence of the first triggering state to the reference signal within a range of the clock mask, adapted for counting a number $Ni$ of instances of occurrence of the first triggering state to the signal under test within a range of the clock mask, adapted for counting a number $Nd2$ of second triggering states occurring to the phase shift signals during a period from termination of the clock mask to occurrence of the first triggering state to the reference signal, and adapted for outputting the count values $Fb$, $M$, $Nb$, $Ni$, $Nd1$, $Nd2$; and a computing device connected to the count generator for receiving the count values and performing computation to obtain the frequency of the signal under test $Fi$ by the equation: $Fi = \{Ni/[Nb + (Nd/M)]\} \times Fb$, wherein $Nd = (Nd1 - Nd2)$, where $M \geqq 2$.
In an embodiment, the count generator comprises a fundamental frequency generating unit, a frequency multiplying unit, and a programmable gate array. The fundamental frequency generating unit generates a fundamental frequency signal. The frequency multiplying unit is connected to the fundamental frequency generating unit for turning the fundamental frequency signal into the reference signal by frequency multiplication. The programmable gate array is connected to the signal input end for receiving the signal under test and to the frequency multiplying unit for receiving the reference signal, generates the count values $M$, $Nb$, $Ni$, $Nd1$, and $Nd2$, and outputs the count values $Fb$, $M$, $Nb$, $Ni$, $Nd1$, and $Nd2$.

In an embodiment, the computing device is one of a control unit and a computer.

In an embodiment, the first triggering state is one of an upper triggering state and a lower triggering state.

In an embodiment, the second triggering state is one of an upper triggering state and a lower triggering state.

In an embodiment, the clock mask comprises the number $N_i$ of cycles of the signal under test, where Ni 2.

In an embodiment, four or eight said phase shift signals are generated.

In an embodiment, the reference signal frequency Fb is directly replaced by a default value.

Accordingly, the present invention provides a method and system for measuring frequency to eliminate measurement errors by quick and precise multiphase processing, multiply the accuracy of measurement in accordance with the quantity of generated phase shift signals, effectuate fully automatic program-based control by means of synchronous triggering, and reduce the area occupied by a circuit.

BRIEF DESCRIPTION OF THE DRAWINGS

Objectives, features, and advantages of the present invention are hereunder illustrated with specific embodiments in conjunction with the accompanying drawings, in which:

FIG 1 is a timing diagram of a method for measuring frequency according to an embodiment of the present invention;
FIG 2 is a flow chart of the method for measuring frequency according to an embodiment of the present invention; and
FIG 3 is a function block diagram of a system for measuring frequency according to an embodiment of the present invention.

DETAILED DESCRIPTION OF THE PREFERRED EMBODIMENTS

The steps of a method for measuring frequency of the present invention are described in specific embodiments thereof and are, unless otherwise specified, interchangeable in terms of sequence. Furthermore, the concept of "connection" used in the description of specific embodiments of a system for measuring frequency according to the present invention is not limited to direction connection; instead, connection can also be effectuated by an intervening element. Also, a "first triggering state" and a "second triggering state" used in the description of the method and system for measuring frequency of the present invention comprise one of an upper-edge triggering state and a lower-edge triggering state. The first triggering state and the second triggering state are not mutually exclusive; hence, both the first triggering state and the second triggering state may be upper-edge triggering states or lower-edge triggering states.

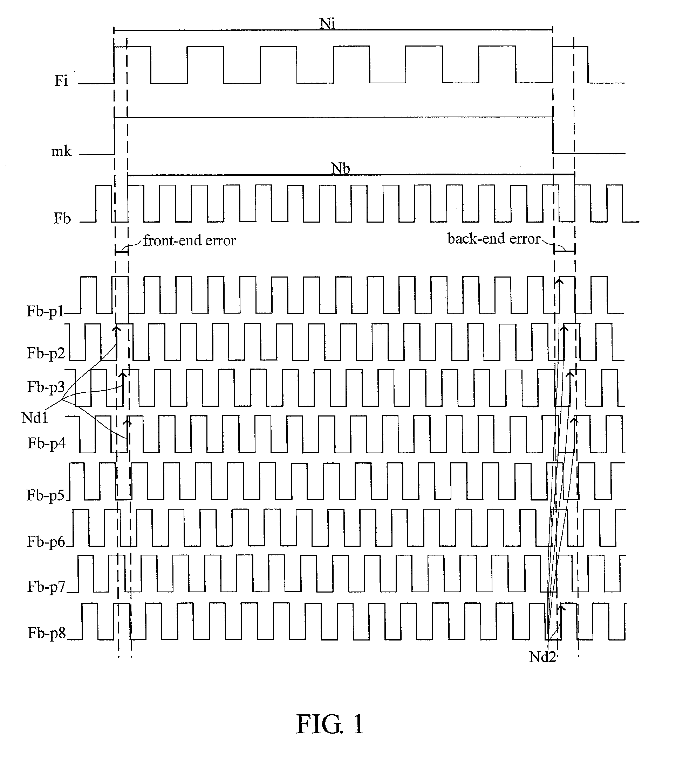

Referring to FIG 1, there is shown a timing diagram of a method for measuring frequency according to an embodiment of the present invention. As shown in FIG 1, this embodiment is exemplified by eight phase shift signals. Persons skilled in the art should be able to understand that, given at least two phase shift signals, the method and system for measuring frequency of the present invention is effective in eliminating measurement errors and thereby enhancing accuracy.

A method for measuring frequency according to an embodiment of the present invention comprises two frequency measurement methods comprising the steps of:

As shown in FIG 1, in addition to an incoming signal under test Fi, measurement is preceded by the step of providing a reference signal Fb and the step of generating multilevel phase shift signals Fb-p1~Fb-p8 of the same frequency based on the reference signal Fb, wherein the phase shift signals Fb-p1~Fb-p8 are spaced apart from each other by a fixed phase.

The reference signal Fb functions as a fundamental frequency for obtaining the frequency of the signal under test. The phase shift signals are generated from the reference signal Fb. Normally, the phase shift of a signal is effectuated by a digital clock manager (DCM) of a programmable gate array (FPGA). In this embodiment, eight phase shift signals Fb-p1~Fb-p8 are processed by two digital clock managers, and the reference signal Fb is decomposed by a digital clock manager to form four phase shift signals. However, persons skilled in the art should be able to understand that a user can still selectively shut down four of the phase shift decomposition processes even with just one digital clock manager. Hence, with only one digital clock manager, it is still possible to decompose the reference signal Fb into two or three phase shift signals. Hence, users can select the quantity of required phase shift signals as needed and as appropriate for operation of a digital clock manager. Regarding the spacing of phase shift signals, a digital clock manager divides 360° into equal phase portions and distributes the equal phase portions among the phase shift signals. For example, the phase equals $360°/(M - 1)$, where M denotes the number of phase shift signals.

Afterward, a clock mask mk is set. The clock mask mk thus set starts from a first triggering state of the signal under test Fi and ends at another first triggering state of the signal under test Fi. In this embodiment, the first triggering state is exemplified by an upper triggering state. Hence, the clock mask mk can be synchronized with the signal under test Fi and thus is triggered synchronously in an upper triggering state of the signal under test Fi. The clock mask mk maintains a high level unless and until a preset number of the signal under tests Fi are performed. Hence, the clock mask mk ends at another first triggering state of the signal under test Fi. In the embodiment illustrated with FIG 1, the clock mask mk ends at the seventh first triggering state of the signal under test Fi, and thus six cycles of the signal under test Fi have passed, that is, the number Ni of cycles of the signal under test Fi equals 6, or Ni = (the number of instances in which the signal under test Fi enters the first triggering state) - 1. The number Ni of cycles of the signal under test Fi must be at least 1 and is preferably at least 2.

Upon initialization of the clock mask mk, measurement kicks off. Referring to FIG 1, the reference signal Fb does not synchronize with the signal under test Fi; hence, the time actually taken to effect the number Nb of cycles of the reference signal Fb measured does not fall within the range of the clock mask mk, thereby resulting in front-end errors and back-end errors. It is because the number Nb of cycles of the reference signal Fb measured is usually counted according to the number of upper triggering states or lower triggering states.

Hence, in an embodiment of the present invention, the front-end and back-end errors are eliminated by means of the phase shift signals.

Regarding the front-end errors, the number Nd1 of second triggering states (upper or lower triggering states) that occur to the phase shift signals Fb-p1~Fb-p8 during the period from the point in time of commencement of the clock mask mk to the point in time when a first triggering state occurs to the reference signal Fb is counted.

Regarding the back-end errors, the number Nd2 of second triggering states (upper or lower triggering states) that occur to the phase shift signals Fb-p1~Fb-p8 during the period from the point in time of termination of the clock mask mk to the point in time when a first triggering state occurs to the reference signal Fb is counted.

Counting the second triggering states that occur to the phase shift signals Fb-p1~Fb-p8 means that elimination of back-end errors requires selecting the upper triggering state as the second triggering state when elimination of front-end errors requires selecting the upper triggering state as the second triggering state, or means that elimination of back-end errors requires selecting the lower triggering state as the second triggering state when elimination of front-end errors requires selecting the lower triggering state as the second triggering state. As shown in FIG 1, the upper triggering state is selected to be the second triggering state, thereby setting Nd1 to 3 and Nd2 to 5.

Subsequent calculation involves subtracting Nd2 from Nd1 to obtain the cycle number that falls within the range of the clock mask mk and needs to be calibrated with a view to eliminating the front-end errors and the back-end errors.

After the aforesaid parameters have been figured out, the frequency of the signal under test Fi is calculated by equation (1) below:

$$Fi = \{Ni/[Nb + (Nd/M)]\} \times Fb \qquad (1)$$

wherein a calibrated value is denoted by Nd and the number of the phase shift signals by M, with Nd = (Nd1 - Nd2) and M 2. In other words, at least two said phase shift signals are generated.

The method according to an embodiment of the present invention enhances accuracy. The fundamental frequency of the signal under test Fi is determined by equation (2) below:

$$(Ni/Fi) = (Nb/Fb) \qquad (2)$$

wherein equation (2) may also be rewritten as equation (3) below:

$$Fi \quad (Ni/Nb) \times Fb \qquad (3)$$

Equation (3) can be satisfied, provided that the frequency of the reference signal Fb is larger than the frequency of the signal under test Fi.

Nonetheless, as revealed above, it is impossible for equation (3) to evaluate the frequency of the signal under test Fi accurately without calibrating the front-end and back-end errors. Accurate calculation necessitates restoration of the front-end errors and removal of the back-end errors in order to conform with the range of the clock mask mk completely. Hence, given the result of the calculation of the calibrated value Nd, it is feasible to evaluate the count value to be finally restored or removed. Furthermore, as indicated by equation (1), accuracy of measurement increases with the quantity of the generated phase shift signals by multiplication. Hence, compared with a convention method which is not based on calibration of front-end errors and back-end errors, the method in an embodiment of the present invention increases accuracy by eight times.

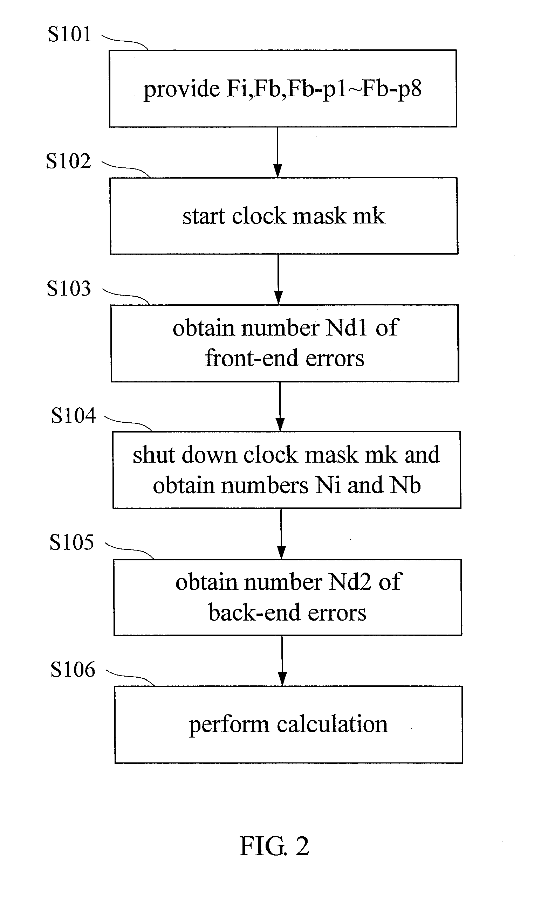

Referring to FIG 1 and FIG 2, there is shown in FIG 2 a flow chart of the method for measuring frequency according to an embodiment of the present invention. As shown in FIG 2, step S101 involves providing the signal under test Fi, the reference signal Fb, and a plurality of phase shift signals Fb-p1~Fb-p8; step S102 involves starting the clock mask mk synchronized with the signal under test Fi; step S103 involves obtaining the number Nd1 of front-end errors; step S104 involves shutting down the clock mask mk and obtaining the cycle numbers Ni and Nb of the signal under test Fi and the reference signal Fb, respectively; step S105 involves obtaining the number Nd2 of back-end errors; and finally step S106 involves performing calculation by equation (1).

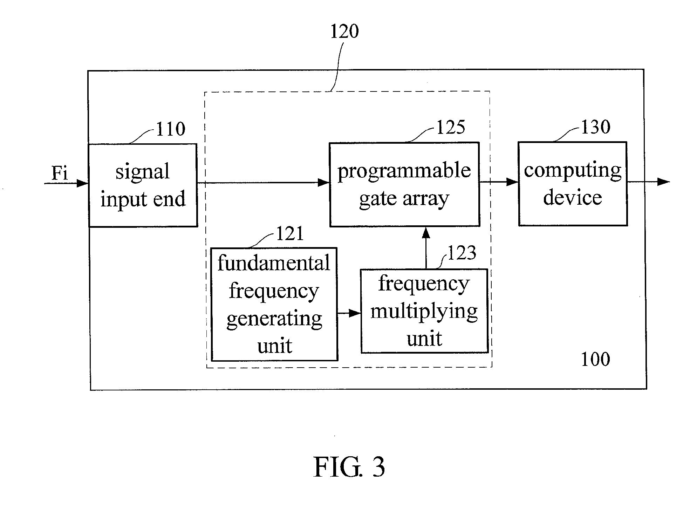

Referring to FIG 3, there is shown a function block diagram of a system for measuring frequency according to an embodiment of the present invention. As shown in FIG 1, a frequency measuring system 100 comprises a signal input end 110, a count generator 120, and a computing device 130.

The signal input end 110 receives the signal under test Fi.

The count generator 120 is connected to the signal input end 110 for receiving the signal under test Fi. The count generator 120 generates the reference signal Fb, M phase shift signals spaced apart from each other by a fixed phase, the clock mask mk, the number Nd1 of second triggering states that occur to the phase shift signals within the range of front-end errors, the number Nb of first triggering states that occur to the reference signal Fb within the clock mask mk, the number Ni of first triggering states that occur to the signal under test Fi within the clock mask mk, the number Nd2 of second triggering states that occur to the phase shift signals within the range of back-end errors, and the count values Fb, M, Nb, Ni, Nd1, and Nd2 to be output.

In an embodiment, the count generator 120 comprises a fundamental frequency generating unit 121, a frequency multiplying unit 123, and a programmable gate array 125. The fundamental frequency generating unit 121 generates a fundamental frequency signal. Normally, a low fundamental frequency is generated by a crystal oscillator to cut costs, and then the fundamental frequency is boosted by the frequency multiplying unit 123 connected to the fundamental frequency generating unit 121 for functioning as the reference signal Fb. Normally, a fundamental frequency is increased to exceed the range of possible frequencies for the signal under test Fi. Hence, the frequency of the reference signal Fb varies from one signal under test to another. The higher the frequency of the reference signal Fb is, the wider is its application. A programmable gate array 125 comprises a digital clock manager for functioning as a phase shift generating circuit, a differential circuit for performing upper or lower differentiation (upper-edge triggering or lower-edge triggering) to count Nd1 and Nd2, and a mask circuit for generating the clock mask mk and counting the signal under test Fi and the reference signal Fb. Accordingly, the programmable gate array 125 generates the count values M, Nb, Ni, Nd1, and Nd2 and outputs the count values Fb, M, Nb, Ni, Nd1, and Nd2.

The programmable gate array is a conventional element. The system for measuring frequency according to an embodiment of the present invention achieve the objectives of the present invention by means of logical elements of the system for measuring frequency. The method for measuring frequency according to an embodiment of the present invention reduces the required number of the logical elements, dispenses with a large-sized programmable gate array chip, and thus reduces the circuit-occupied area and downsizes the product. For example, if the computing function of a computing device is also incorporated into the programmable gate array, the required number of the logical elements will be greatly increased, thereby increasing the circuit-occupied area. Due to its structural design, the programmable gate array is of a low computation capacity and operates at a low speed and thus is not suitable for use in computation. Although a special high-priced programmable gate array can perform high-speed computation, it incurs an excessively high cost.

The computing device 130 is connected to the count generator 120 for receiving the count values and performing computation by equation (1) to obtain the frequency of the signal under test Fi. The computing device 130 is a control unit (MCU) or a computer. If the computing device 130 is a control unit, then the control unit is usually disposed on the same circuit board as the count generator 120 is, such that the frequency measuring system 100 in its entirety is integrated onto a module; however, the computing device 130 can also be an external computer device for processing a computation procedure in whole with data provided by a measuring module.

To reduce errors further, it is feasible to perform a high-precision measurement process on the generated reference signal Fb beforehand. To preclude any error which might otherwise be produced as a result of a discrepancy between a frequency actually generated by a fundamental frequency generating unit and a frequency multiplier and a given frequency level, it is feasible to measure the reference signal Fb in advance by means of a high-precision frequency counter having a higher resolution than the frequency of the reference signal Fb, and then use the measured reference signal Fb as a default value to be directly stored in the computing device 130. In doing so, in every instance of measurement, the default value always applies to the frequency of the reference signal Fb, thereby dispensing with the need to use a parameter set forth in the specifications of a fundamental frequency generating unit and a frequency multiplier.

In conclusion, a method and system for measuring frequency of the present invention eliminate measurement errors by quick and precise multiphase processing and multiply the accuracy of measurement in accordance with the quantity of generated phase shift signals. An embodiment of the present invention achieves eightfold reduction (corresponding to eight phase shift signals) in errors, effectuates fully automatic program-based control by means of synchronous triggering, and reduces the area occupied by a circuit.

The present invention is disclosed above by preferred embodiments. However, persons skilled in the art should understand that the preferred embodiments are illustrative of the present invention only, but should not be interpreted as restrictive of the scope of the present invention. Hence, all equivalent modifications and replacements made to the aforesaid embodiments should fall within the scope of the present invention. Accordingly, the legal protection for the present invention should be defined by the appended claims.

**Claims**

1. A method for measuring frequency, the method being for use in measuring a signal under test, the method comprising the steps of:

   providing a reference signal;
   generating a plurality of phase shift signals of a same frequency based on the reference signal, the phase shift signals being spaced apart from each other by a fixed phase;
   setting a clock mask, the clock mask starting from a first triggering state of the signal under test and ending at another first triggering state of the signal under test;
   counting a number $Nd1$ of second triggering states occurring to the phase shift signals during a period from commencement of the clock mask to occurrence of a first triggering state to the reference signal;
   counting a number $Nb$ of cycles of the reference signal within a range of the clock mask;
   counting a number $Ni$ of cycles of the signal under test within a range of the clock mask;
   counting a number $Nd2$ of second triggering states occurring to the phase shift signals during a period from termination of the clock mask to occurrence of a first triggering state to the reference signal; and
   obtaining the frequency of the signal under test $Fi$ by the equation below:

   $$Fi = \{Ni/[Nb + (Nd/M)]\} \times Fb$$

   wherein a frequency of the reference signal is denoted by $Fb$ and a number of the phase shift signals by $M$, with $Nd = (Nd1 - Nd2)$ and $M \, 2$.

2. The method of claim 1, wherein the first triggering state is one of an upper triggering state and a lower triggering state.

3. The method of claim 1, wherein the second triggering state is one of an upper triggering state and a lower triggering state.

4. The method of claim 1, wherein the clock mask comprises the number $Ni$ of cycles of the signal under test, where $Ni \, 2$.

5. The method of claim 1, wherein four or eight said phase shift signals are generated.

6. The method of claim 1, further comprising replacing the reference signal frequency $Fb$ with a default value.

7. The method of claim 1, wherein the fixed phase equals $360°/(M - 1)$.

8. A system for measuring frequency, the system being for measuring a signal under test, the system comprising:

   a signal input end for receiving the signal under test;
   a count generator connected to the signal input end for receiving the signal under test, adapted for generating a reference signal of a frequency $Fb$, adapted for generating $M$ phase shift signals which are based on the reference signal, have a same frequency, and are spaced apart from each other by a fixed phase, adapted for generating a clock mask starting from a first triggering state of the signal under test and ending at another first triggering state of the signal under test, adapted for counting a number $Nd1$ of second triggering states occurring to the phase shift signals during a period from commencement of the clock mask to occurrence of a first triggering state to the reference signal, adapted for counting a number $Nb$ of instances of occurrence of the first triggering state to the reference signal within a range of the clock mask, adapted for counting a number $Ni$ of instances of occurrence of the first triggering state to the signal under test within a range of the clock mask, adapted for counting a number Nd2 of second triggering states occurring to the phase shift signals during a period from termination of the clock mask to occurrence of the first triggering state to the reference signal, and adapted for outputting the count values Fb, M, Nb, Ni, Nd1, Nd2; and
a computing device connected to the count generator for receiving the count values and performing computation to obtain the frequency of the signal under test Fi by the equation below:

$$Fi = \{Ni/[Nb + (Nd/M)]\} \times Fb$$

wherein

$$Nd = (Nd1 - Nd2), \text{ where } M \quad 2.$$

9. The system of claim 8, wherein the count generator comprising:

a fundamental frequency generating unit for generating a fundamental frequency signal;
a frequency multiplying unit connected to the fundamental frequency generating unit for turning the fundamental frequency signal into the reference signal by frequency multiplication; and
a programmable gate array connected to the signal input end for receiving the signal under test, connected to the frequency multiplying unit for receiving the reference signal, and adapted for generating the count values M, Nb, Ni, Nd1, Nd2 and outputting the count values Fb, M, Nb, Ni, Nd1, Nd2.

10. The system of claim 9, wherein the computing device replaces the count value Fb with a default value.

11. The system of claim 8, wherein the computing device is one of a control unit and a computer.

12. The system of claim 8, wherein the first triggering state is one of an upper triggering state and a lower triggering state, and the second triggering state is one of an upper triggering state and a lower triggering state.

FIG. 1

S101

provide Fi,Fb,Fb-p1~Fb-p8

S102

start clock mask mk

S103

obtain number Nd1 of
front-end errors

S104

shut down clock mask mk and
obtain numbers Ni and Nb

S105

obtain number Nd2 of
back-end errors

S106

perform calculation

FIG. 2

FIG. 3

Europäisches
Patentamt

European
Patent Office

Office européen
des brevets

# EUROPEAN SEARCH REPORT

**Application Number**

EP 11 18 2869

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 102 116 797 A (TIANJIN 764 COMM AND NAVIGATION TECHNOLOGY CO LTD) 6 July 2011 (2011-07-06) * abstract; claims 1,2; figures 1-3 * * paragraphs [0003], [0009] - [0014] * | 1-12 | INV. G01R23/15 G01R23/10 |
| Y | US 2006/155512 A1 (ARIAV ARIE [IL] ET AL) 13 July 2006 (2006-07-13) * abstract; claims 1-3,5,7,21-23,25,27,28; figures 2,3 * * paragraphs [0048], [0053] - [0057], [0059] * | 1-12 | |
| L | JP 2011 232143 A (SEIKO EPSON CORP) 17 November 2011 (2011-11-17) * abstract; figures 8-10 * | 1-12 | |
| A | JP 1 062913 A (MATSUSHITA ELECTRIC IND CO LTD) 9 March 1989 (1989-03-09) * abstract; figures * | 1,8 | |
| A | WO 92/04634 A1 (SUNDSTRAND DATA CONTROL [US]) 19 March 1992 (1992-03-19) * abstract; figures 3-5 * | 1,8 | TECHNICAL FIELDS SEARCHED (IPC) G01R H03L G01N |
| A | EP 1 227 591 A1 (FUJITSU LTD [JP]) 31 July 2002 (2002-07-31) * abstract; figures 2-8 * | 1,8 | |

The present search report has been drawn up for all claims

| Place of search | Date of completion of the search | Examiner |
|---|---|---|
| Berlin | 2 November 2012 | Fritz, Stephan C. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                             

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 11 18 2869

This annex lists the patent family members relating to the patent documents cited in the above-mentioned European search report.
The members are as contained in the European Patent Office EDP file on
The European Patent Office is in no way liable for these particulars which are merely given for the purpose of information.

02-11-2012

| Patent document cited in search report | | | Publication date | Patent family member(s) | | | Publication date |
|---|---|---|---|---|---|---|---|
| CN | 102116797 | A | 06-07-2011 | NONE | | | |
| US | 2006155512 | A1 | 13-07-2006 | IL | 166292 | A | 18-11-2009 |
| | | | | US | 2006155512 | A1 | 13-07-2006 |
| JP | 2011232143 | A | 17-11-2011 | NONE | | | |
| JP | 1062913 | A | 09-03-1989 | JP | 1062913 | A | 09-03-1989 |
| | | | | JP | 2563366 | B2 | 11-12-1996 |
| WO | 9204634 | A1 | 19-03-1992 | CA | 2091349 | A1 | 13-03-1992 |
| | | | | DE | 69123592 | D1 | 23-01-1997 |
| | | | | EP | 0548253 | A1 | 30-06-1993 |
| | | | | JP | 3591835 | B2 | 24-11-2004 |
| | | | | JP | H06501554 | A | 17-02-1994 |
| | | | | US | 5095264 | A | 10-03-1992 |
| | | | | WO | 9204634 | A1 | 19-03-1992 |
| EP | 1227591 | A1 | 31-07-2002 | CN | 1379929 | A | 13-11-2002 |
| | | | | DE | 60025732 | T2 | 20-07-2006 |
| | | | | EP | 1227591 | A1 | 31-07-2002 |
| | | | | JP | 3691310 | B2 | 07-09-2005 |
| | | | | JP | 2001119291 | A | 27-04-2001 |
| | | | | US | 6674277 | B1 | 06-01-2004 |
| | | | | US | 2004100245 | A1 | 27-05-2004 |
| | | | | WO | 0129969 | A1 | 26-04-2001 |

EPO FORM P0459

For more details about this annex : see Official Journal of the European Patent Office, No. 12/82